(19) Europäisches Patentamt
European Patent Office
Office européen des brevets

(11) **EP 2 337 287 A2**

(12) **EUROPEAN PATENT APPLICATION**

(43) Date of publication:
**22.06.2011 Bulletin 2011/25**

(51) Int Cl.:
***H04L 25/02*** *(2006.01)* ***H03H 21/00*** *(2006.01)*

(21) Application number: **10193899.1**

(22) Date of filing: **07.12.2010**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **18.12.2009 KR 20090127052**
**25.05.2010 KR 20100048762**

(71) Applicant: **Electronics and Telecommunications Research Institute**
**Daejeon 305-350 (KR)**

(72) Inventors:
- **Nam, Seung-Hyun**
**305-350, Daejeon (KR)**
- **Kim, Hee-Wook**
**305-308, Daejeon (KR)**
- **Kang, Kun-Seok**
**305-804, Daejeon (KR)**
- **Ahn, Do-Seob**
**305-762, Daejeon (KR)**
- **Lee, Ho-Jin**
**305-761, Daejeon (KR)**

(74) Representative: **Betten & Resch**
**Patentanwälte**
**Theatinerstrasse 8**
**80333 München (DE)**

(54) **Low-complexity Kalman filter channel estimation method for orthogonal frequency division multiplexing system**

(57) Disclosed herein is a Kalman filter channel estimation method for an OFDM system. The Kalman filter channel estimation method for an OFDM system includes estimating a channel using a least squares based on a reference signal location, calculating Kalman gain for the estimated channel, and updating the estimated channel in accordance with the calculated Kalman gain, wherein the calculating the Kalman gain includes obtaining the Kalman gain using a quasi-Newlon technique.

FIG.4

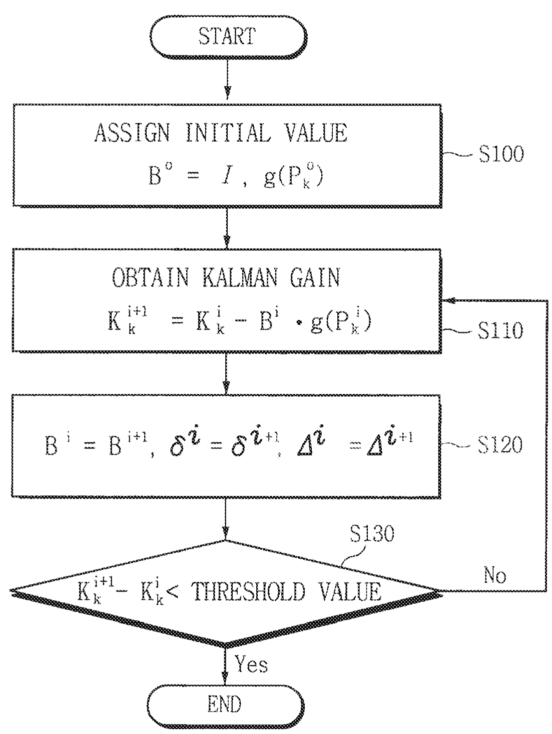


EP 2 337 287 A2

## Description

CROSS REFERENCE TO RELATED APPLICATIONS

This application claims the benefit of Korean Patent Application No. 10-2009-0127052 filed on December 18, 2009 and entitled "A Low-complexity Kalman Filter Channel Estimation method for Orthogonal Frequency Division Multiplexing System" and Korean Patent Application No. 10-2010-0048762 filed on May 25, 2010 and entitled "A Low-complexity Kalman Filter Channel Estimation method for Orthogonal Frequency Division Multiplexing System," which are hereby incorporated by reference in their entirety into this application.

BACKGROUND OF THE INVENTION

1. Technical Field

The present invention relates generally to a method of estimating the channel of a receiver in an Orthogonal Frequency Division Multiplexing (OFDM) system, and, more particularly, to a method of estimating the channel of a receiver in an OFDM system, which is capable of reducing complexity at a channel estimation step by using a Kalman filter, and a Kalman filter to which the method is applied.

The present invention was conceived of during the course of research that was conducted as part of a fundamental information technology development project that was sponsored by the Korean Ministry of Knowledge Economy [Task Administration Number: 2008-F-010-02; Title of Task: Development of IMT-Advanced Satellite Access Technology (related to standardization)] .

2. Description of the Related Art

An OFDM system is a high-frequency efficiency system because it exhibits robust performance in the face of high multi-path fading and a frequency selective channel, and is widely used. Furthermore, various multimedia services based on the cooperation between a terrestrial network and a satellite network are rapidly growing alongside the convergence of communication, broadcasting, computing and household electronic technologies. With the popularization of wireless communication, the transmission of a large amount of data, such as images, is required. It is impossible for receivers distributed at a plurality of locations across a broadcasting and communication service area to be free from the influence of a variety of radiant wave signals, including a transmitted original signal, and channel noise. Accordingly, in order to overcome this physical situation, enhancing the transmission output of signals to be transmitted was attempted in an effort to improve conditions. However, the use of this method results in further narrowing the limitation of a limited channel, so that the corresponding frequency cannot be used in some other area, thereby further narrowing the wireless frequency band.

In order to overcome this problem, research into channel estimation has been actively conducted, and accurate channel estimation is considered important to guaranteeing that the transmitted data is highly reliable and trustworthy. The estimation of channel state information which is used to recover a transmitted signal from a received signal highly affects the performance of a system. An estimation technique using the insertion of pilots into the frequency axis is generally used to estimate channel state information and recover a received signal. In the case of the OFDM-based pilots of the 3GPP Long Term Evolution (LTE), channel estimation should be performed only using pilot symbols previously known to transmitting and receiving ends.

Furthermore, as the demand for mobile receivers is increasing, a channel, the characteristics of which vary over time, should be estimated.

A method of obtaining channel estimation values at all OFDM subcarrier locations by first estimating a channel transfer function at a pilot location and then interpolating the channel transfer function in the time and frequency domains is disclosed as the above conventional method. However, this method is problematic in that it is difficult to perform efficient channel estimation in a system which is in a poor channel environment and which has limited power for devices and size limitations, such as a satellite communication system.

Furthermore, in another conventional technology, it is known that a simplified Kalman filter is very effective in eliminating a noise effect and the performance of the entire system can be improved up to 2 dB. However, it is still difficult to perform efficient channel estimation using such a simplified Kalman filter in a system which is in a poor channel environment and which has limited power for devices and size limitations, such as a satellite communication system.

Furthermore, in still another conventional technology, a system for estimating and tracking a channel to perform wireless OFDM modulation uses distributed pilot symbols dependent on channel conditions, uses a plurality of received pilot symbols, and estimates a channel value based on the correlation between channel conditions depending on the passage of time, and a Kalman filter is used to track a channel. This method is still problematic in that it is difficult to perform efficient channel estimation in a system which is in a poor channel environment and which has limited power for devices and size limitations, such as a satellite communication system.

SUMMARY OF THE INVENTION

Accordingly, the present invention has been made keeping in mind the above problems occurring in the prior art, and an object of the present invention is to provide a low-complexity Kalman filter channel estimation method for an OFDM system, which enables precise channel estimation to be implemented using a reduced complexity Kalman filter in an environment which has limited power for devices and size limitations so that the precise channel estimation can be performed to recover transmitted signals in an environment in which channel characteristics are very poor, such as that of a satellite communication system, and a Kalman filter to which the method is applied.

In order to accomplish the above object, the present invention providers a Kalman filter channel estimation method for an OFDM system, including estimating a channel using a least squares based on a reference signal location; calculating Kalman gain for the estimated channel; and updating the estimated channel in accordance with the calculated Kalman gain; wherein the calculating the Kalman gain includes obtaining the Kalman gain using a quasi-Newton technique.

The estimating the channel may be used both in a time axis and in a frequency axis by a Reference Signal (RS).

The Kalman filter channel estimation method may further include, before the calculating the Kalman gain, setting up an autoregressive model; and propagating an error covariance.

The obtaining the Kalman gain may include performing an iterative calculation using the quasi-Newton technique in order to obtain the Kalman gain.

The iterative calculation may be performed until a resulting value becomes lower than a preset threshold value.

The Kalman gain based on the quasi-Newton technique may be obtained using the following equation:

$$K_k^{i+1} = K_k^i - B^i \cdot g({P_k}^i)$$

where *B* is a positive definite matrix, $g(P_k)$ is a slope of error covariance, and *i* is an index indicating a number of repetitions of the quasi-Newton technique.

The positive definite matrix B may satisfy the following equation:

DFP technique-based

$$B^{i+1} = \left(I - \frac{\Delta^i (\delta^i)^T}{(\Delta^i)^T \delta^i}\right) B^i \left(I - \frac{\delta^i (\Delta^i)^T}{(\Delta^i)^T \delta^i}\right) + \frac{\Delta^i (\Delta^i)^T}{(\Delta^i)^T \delta^i}$$

where Δ' $=g(P_k^{i+1})$ $g(P_k')$, and δ' $=P_k^{i+1}$ $P_k^i$

he positive definite matrix B may satisfy the following equation:

BFGS technique-based

$$B^{i+1} = B^i + \frac{\Delta^i (\Delta^i)^T}{(\Delta^i)^T \delta^i} - \frac{B^i \delta^i (B^i \Delta^i)^T}{(\delta^i)^T B^i \delta^i}$$

where Δ' $g(P_k^{i+1})$-$g(P_k^i)$, and δ' $=P_k^{i+1}$-$P_k^i$

The positive definite matrix B may satisfy the following equation:

Broyden technique-based

$$B^{i+1} = B^i + \frac{\Delta^i - B^i \delta^i}{(\delta^i)^T \delta^i} (\delta^i)^T$$

where $\Delta' = g(P_k^{i+1}) - g(P_k^i)$ and $\delta^i = P_k^{i+1} - P_k^i$ .

The positive definite matrix B may satisfy the following equation:

Broyden Family technique-based

$$B^{i+1} = (1 - \varphi_i) B_{BFGS}^i + \varphi_i B_{DFP}^i, \varphi_i \in [0,1].$$

The positive definite matrix B may satisfy the following equation:

SR1 technique-based

$$B^{i+1} = B^i + \frac{(\Delta^i - B^i \delta^i)(\Delta^i - B^i \delta^i)^T}{(\Delta^i - B^i \delta^i)^T \delta^i}$$

where $\Delta'$ $g(P_k^{i+1}) - g(P_k^i)$, and $\delta^i = P_k^{i+1} - P_k^i$.

BRIEF DESCRIPTION OF THE DRAWINGS

The above and other object, features and advantages of the present invention will be more clearly understood from the following detailed description taken in conjunction the accompanying drawings, in which:

FIG. 1 is a diagram showing the structure of the radio frame structure type 1 of an OFDM-based Long Term Evolution (LTE) system;
FIG. 2 is a diagram showing the arrangement of reference signals for channel estimation in an LTEsystem;
FIG. 3 is a diagram showing the flow of the operation of a Kalman filter-based channel estimation technique which is the basis of the present invention;
FIG. 4 is a diagram showing the flow of a Kalman filter channel estimation technique to which a quasi-Newton algorithm has been applied; and
FIG. 5 is a table showing various techniques of the quasi-Newton algorithm which are applied to the present invention.

DESCRIPTION OF THE PREFERRED EMBODIMENTS

Reference now should be made to the drawings, in which the same reference numerals are used throughout the different drawings to designate the same or similar components.

A Kalman filter channel estimation method having low complexity in an OFDM system according to preferred embodiments of the present invention will be described in detail below.

FIG. 1 is a diagram showing the structure of the radio frame structure type 1 of an OFDM-based LTE system.

Referring to FIG. 1 the radio frame structure type 1 uses Frequency Division Duplex (FDD) which supports both full duplex communication and half duplex communication. Each frame performs transmission in the radio flame period $T_{siot}$ =15360x$T_s$ = *0.5 ms* using 20 slots each having the slot period $T_f$ = 307200 x $T_s$ = 1 0 ms along the time axis, and two neighboring slots, that is, a subframe, has a transmission time interval of 1 ms. The present invention may be used not only for an LTE system but also for a system which uses reference signals (RS) or pilots.

FIG. 2 is a diagram showing the arrangement of reference signals for channel estimation in an LTE system.

FIG. 2 shows reference signals RSs which transmitting and receiving ends had previous knowledge of and which, instead of the transmission of data, are used to perform channel estimation in the basic LTE system described in conjunction with FIG. 1. Downlink RSs may be divided into cell-specific RSs, MBSFN RSs, and UE-specific RSs. RSs, the number of which is equal to the number of downlink antennas, are sent

FIG. 3 is a diagram showing the flow of the operation of a Kalman filter-based. channel estimation technique which is the basis of the present invention.

Referring to FIG. 3, the Kalman filter-based channel estimation technique according to the present invention includes a channel estimation step S10 using a least squares algorithm based on the locations of reference signals, an autoregressive model setup step S20, an error covariance propagation step S30, a Kalman gain calculation step S40, a channel estimation value update step S50, an interpolation performance step S60, a channel compensation step S70, and an error covariance update step S80.

A Kalman filter channel adaptive estimator to which the present invention is applied uses a method which performs estimation by updating parameters depending on variations in the statistical characteristics of the channel. The Kalman filter channel estimator is one of the adaptive estimators which are used to estimate a fading channel in an OFDM system, and uses an effective recursive technique which estimates the state of a dynamical system based on noise measurements.

In general, the Kalman filter is a recursive filter which tracks the state of a linear dynamical system including noise, and was developed by Rudolf E. Kalman. The Kalman filter is used in various fields, such as computer vision, robot engineering and radars, and, in many cases, exhibits very efficient performance.

The Kalman filter operates based on a discrete-time linear dynamical system, and premises a Markov chain in which a state vector at each time depends only on vectors at previous times. If the state vector at a specific time k is defined as $X_k$ and the user input at the time is defined as $u_k$, the Kalman filter assumes the following relation:

$$X_k = F_k X_{k-1} + B_k u_k + W_k$$

where $F_k$ is a state transition matrix at a corresponding time based on a previous state, $B_k$, is a state transition a matrix based on a user's a input, and $W_k$ is a multivariate normal distribution $W_k \sim N(0, Q_k)$ noise factor with the covariance matrix $Q_k$.

Furthermore, the state vector $X_k$ and a vector $Z_k$ actually obtained by measuring $X_k$ have the following relation:

$$Z_k = H_k X_k + V_k$$

where $H_k$ is a matrix related to measurements at a corresponding time, and $V_k$ is a multivariate normal distribution $W_k \sim N(0, R_k)$ noise factor with the covariance matrix $R_k$ .

Furthermore, the assumption that an initial state and individual noise variables $\{X_o, W_1, ..., W_k\ V_i, ..., V_k\}$are not dependent on each other is required.

In many cases, an actual dynamical system does not exactly conform with this model. In particular, in the case of a system which does not conform with principal assumptions such as linearity or mutual independence, the performance of the Kalman filter may be considerably deteriorated or the value may diverge. Since the estimation method using a Kalman filter can be easily understood on the basis of well-known technology, a detailed description thereof will be omitted here.

In the present invention, the Kalman filter may be applied to the estimation of a time-varying channel, and the state of the channel may be represented by an autoregressive model because the state of the channel reflects the statistic characteristics of the time-varying channel. The design of the autoregressive model may be performed using various methods, and, in the present embodiment, the $p$ - order autoregressive model of the time-varying channel may be expressed as follows:

$$H_{k+1} = -\sum_{i=1}^{p} A_{(i)} H_{(k-i)} + W_k,$$

$$Y_{(k)} = H_k X_k + V_k$$

where He is the frequency response of a channel at the location of a reference signal RS, In order to obtain a(1),..., *a* (*p*) and $W_k$, the following equation can be used.

$$R_{HH}(m) = E\{H_k H_{k-m}^{*}\} = J_0(2\pi f_d T m)$$

where $f_d$ is the maximum Doppler frequency, and *T* is the interval between OFDM symbols. The autocorrelation value of the channel may be obtained using the Bessel function of the first kind of order 0 $J_0$ (.), and A and $W_k$ may be obtained using the Yule-Wakler equation based on the autoregressive model of the channel. Here, $W_k$ *and* $V_k$ are zero mean Gaussian noise, are independent of samples, and have the characteristic $E(W_k^2) = Q$ and the characteristic $E(V_k^2) = Q$ , respectively.

The Kalman filter operates in such a way as to propagate the covariance and average of the state over time. When an equation representing the way in which the covariance and average of the state propagate over time is created, the Kalman filter operates to perform the following two steps:

1. Estimation: The average and covariance of the state are acquired.
2. Correction: At each time, a measurement is acquired, and the average and covariance of each state are updated.

This approach acts as a filter, estimates a current sample based on a previous sample, and is performed in a recursive manner. Such functionality of the Kalman filter has found widespread application.

In the Kalman filter channel estimation algorithm, Least Squares (LS) estimation can be performed using reference signals RSs, the locations of the subcarrier of which are known to receiving and transmitting ends. If the subcarrier index of a reference signal RS is *P* , the frequency response of the channel is as follows:

$$\hat{H}_{LS}(p) = \frac{Y_{LS}(p)}{X_{LS}(p)}, \quad p = 0,1,\cdots,P-1$$

The present invention is intended to accurately estimate frequency channel responses at the locations of reference signals using a Kalman filter before frequency-side channel responses estimated at the locations of the subcarriers of the reference signals using least squares estimation are interpolated for all of the subcarriers. The autoregressive model for the time-varying channel to be estimated was represented by the equation, as described above.

Since the locations of the reference signals RSs are repeated at the intervals of the locations of six subcarriers, as shown in FIG. 2, $\check{H}$ is the size of a subcarrier which belongs to the size of all of the subcarriers and corresponds to a corresponding reference signal RS, that is, a PxP matrix. The frequency component of the estimated channel is inserted orthogonally. In the following equation, index *k* is the OFDM symbol, and it is assumed that the characteristics of the channel do not vary during a single OFDM symbol due to the Doppler effect. The steps of the Kalman filter may be divided into two steps, that is, an estimation step and a correction step, as described above:

Estimation:

Step 1. Autoregressive model setup (step S20 of FIG. 3):

This step is modeled by $\widehat{H}_k^- = A_k \widehat{H}_{k-1},$ and the following expression is obtained using the autoregressive characteristics:

$$\widehat{H}_k = \widehat{H}_{k-1} + K(innovation) = \widehat{H}_{k-1} + K(Y_k - \widehat{H}_{k-1} X_k)$$

Step 2. Error covariance propagation (step S30 of FIG. 3)

$$P_k^- = E[(e_k)(e_k)^H] = E\left[(H_k - \widehat{H}_k^-)(H_k - \widehat{H}_k^-)^H\right] = A_{k-1} P_{k-1} A_k^H + Q_{k-1}$$

Correction:

Step 3. Kalman gain (step S40 of FIG. 3)

$$K_k = P_k^- H_k^H [H_k P_k^- H_k^H + R_k]^{-1}$$

Step 4. Update (step S50 of FIG. 3)

$$\widehat{H}_k = \widehat{H}_k^- + K_k(Y_k - \widehat{H}_k^- X_k)$$

Step 5. Error covariance update (FIG. 3 of step S80)

$$P_k = (I - K_k H_k) P_k^-$$

Here, the Kalman gain *K* is required to obtain *P* having the minimum covariance error value, and can be obtained by differentiating *P.* In the above example, a 1-order autoregressive model was used. Innovation e represents the difference between the actual channel frequency response and the estimated channel Frequency response.

FIG. 4 is a diagram showing an example in which a quasi-Newton algorithm has been applied to the step of obtaining the Kalman gain. The purpose of applying the quasi-Newton algorithm is to reduce complexity by avoiding inverse matrix operations, In general, it is known that inverse matrix operation requires a complexity corresponding to the third power of the matrix size $O(N^3)$. However, by introducing the quasi-Newton algorithm, the complexity can be reduced to the square of the matrix size. Since the quasi-Newton technique is an approach based on iterative performance, it is apparent that the calculation of the number of repetition (the number of repetitions x $O(N^2)$). In order to introduce the quasi-Newton algorithm, the error-related covariance which was expressed in a simple manner above needs to be expressed again, as follows:

$$P_k = P_k^- - K_k H_k P_k^- - P_k^- H_k^T K_k^T + K_k (H_k P_k^- H_k^T + R_k) K_k^T$$

The Kalman gain is a value which is used to minimize the error covariance, and the equation of step 3 can be obtained by differentiating $P_k^-$ with respect to $K_k$ and can be expressed, as follows:

$$\frac{\partial \mathrm{P}_k}{\partial \mathrm{K}_k} = g(\mathrm{P}_k) = -2(\mathrm{H}_k \mathrm{P}_k^-)^T + 2\mathrm{K}_k(\mathrm{H}_k \mathrm{P}_k^- \mathrm{H}_k^T + R_k)$$

The above Equation is the slope of $P_k^-$, is represented by $g(P_k)$, and can be expressed according the quasi-Newton algorithm, as follows:

$$\mathrm{K}_k^{i+1} = \mathrm{K}_k^i - \mathrm{B}^i \cdot g(\mathrm{P}_k{}^i)$$

where $B$ is a positive definite matrix, and $i$ is an index indicating the number of repetitions based on the quasi-Newton algorithm.

In the above Equation, the inverse matrix operation required to obtain the Kalman gain is not necessary in the method using the quasi-Newton algorithm, but an iterative calculation is performer instead.

The iterative calculation is performed until the difference between $K_k^{i+1}$ obtained by the ($i$ + 1) - *th* iterative calculation of the quasi-Newton algorithm and $K_k^i$ obtained by the ($i$) -*th* iterative calculation becomes lower than a specific predetermined threshold value. When this is satisfied, the iterative calculation of the quasi-Newton algorithm which is performed to obtain the Kalman gain is terminated.

FIG. 5 is a table showing techniques for calculating a positive definite matrix B which are frequently used for the Kalman gain calculation which is applied to the present invention.

The following techniques for updating the positive definite matrix B, which are shown in the table, are presented to propose the introduction of the quasi-Newton algorithm in the present invention, other quasi-Newton techniques may be used. Since the following various methods of obtaining the positive definite matrix B are well known, detailed descriptions thereof will be omitted here.

The Kalman gain based on the above-described quasi-Newton algorithm is obtained using the equation $\mathrm{K}_k^{i+1} = \mathrm{K}_k^i - \mathrm{B}^i \cdot g(\mathrm{P}_k{}^i)$, where $B$ is a positive definite matrix, $g(P_k)$ is the slope of the error covariance, and $i$ is an index indicating the number of repetitions of the quasi-Newton algorithm.

Here, it is preferred that the positive definite matrix B satisfy DFP technique-based

$$B^{i+1} = \left(I - \frac{\Delta^i(\delta^i)^T}{(\Delta^i)^T\delta^i}\right)B^i\left(I - \frac{\delta^i(\Delta^i)^T}{(\Delta^i)^T\delta^i}\right) + \frac{\Delta^i(\Delta^i)^T}{(\Delta^i)^T\delta^i}$$

where

$$\Delta^i = g(P_k{}^{i+1}) - g(P_k{}^i), \text{ and } \delta^i = P_k{}^{i+1} - P_k{}^i.$$

Furthermore, it is preferred that the positive definite matrix $B$ satisfy BFGS technique-based

$$B^{i+1} = B^i + \frac{\Delta^i(\Delta^i)^T}{(\Delta^i)^T\delta^i} - \frac{B^i\delta^i(B^i\Delta^i)^T}{(\delta^i)^T B^i\delta^i}$$

where

$$\Delta^i = g(P_k^{i+1}) - g(P_k^i), \text{ and } \delta^i = P_k^{i+1} - P_k^i.$$

Furthermore, it is preferred that the positive definite matrix *B* satisfy Broyden technique-based

$$B^{i+1} = B^i + \frac{\Delta^i - B^i\delta^i}{(\delta^i)^T\delta^i}(\delta^i)^T$$

where

$$\Delta^i = g(P_k^{i+1}) - g(P_k^i), \text{ and } \delta^i = P_k^{i+1} - P_k^i.$$

Furthermore, it is preferred that the positive definite matrix *B* satisfy Broyden family technique-based

$$B^{i+1} = (1-\varphi_i)B^i_{BFGS} + \varphi_i B^i_{DFP}, \varphi_i \in [0,1].$$

Furthermore, it is preferred that the positive definite matrix *B* satisfy SR1 technique-based

$$B^{i+1} = B^i + \frac{(\Delta^i - B^i\delta^i)(\Delta^i - B^i\delta^i)^T}{(\Delta^i - B^i\delta^i)^T\delta^i}$$

where

$$\Delta^i = g(P_k^{i+1}) - g(P_k^i), \text{ and } \delta^i = P_k^{i+1} - P_k^i.$$

The above-described present invention has the advantage of being able to perform efficient channel estimation using a Kalman filter of low complexity in a system in which a channel environment is poor and which has limited power for devices and size limitations, such as a satellite communication system.

That is, a Kalman filter channel estimation, method capable of effectively eliminating interference, occurring due to the Doppler effect, and thermal noise using the correlation between channels is effective.

The inverse matrix required to calculate the Kalman gain requires high complexity. Therefore, in the present invention, the inverse matrix operation is eliminated by applying the quasi-Newton technique to the process of obtaining the Kalman gain, resulting in a reduction in complexity, which means that the cost required to design the chip of a receiver and the size of the chip can be considerably reduced.

Although the prepared embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A Kalman filter channel estimation method for an Orthogonal Frequency Division Multiplexing (OFDM) system, comprising:

   estimating a channel using a least squares based on a reference signal location;
   calculating Kalman gain for the estimated channel; and
   updating the estimated channel in accordance with the calculated Kalman gain;
   wherein the calculating the Kalman gain comprises obtaining the Kalman gain using a quasi-Newton technique.

2. The Kalman filter channel estimation method as set forth in claim 1 wherein the estimating the channel can be used both in a time axis and in a frequency axis by a Reference Signal (RS).

3. The Kalman filter channel estimation method as set forth in claim 1 or 2, further comprising, before the calculating the Kalman gain:

   setting up an autoregressive model; and
   propagating an error covariance.

4. The Kalman filter channel estimation method as set forth in claim 1, 2, or 3, wherein the obtaining the Kalman gain comprises performing an iterative calculation using the quasi-Newton technique in order to obtain the Kalman gain.

5. The Kalman filter channel estimation method as set forth in claim 4, wherein the iterative calculation is performed until a resulting value becomes lower than a preset threshold value.

6. The Kalman filter channel estimation method as set forth in one of claims 1 to 5, wherein the Kalman gain based on the quasi-Newton technique is obtained using the following equation:

$$\mathrm{K}_k^{i+1} = \mathrm{K}_k^{i} - \mathrm{B}^{i} \cdot g(\mathrm{P}_k{}^{i})$$

   where B is a positive definite matrix, $g(P_k)$ is a slope of error covariance, and $i$ is an index indicating a number of repetitions of the quasi-Newton technique.

7. The Kalman filter channel estimation method as set forth in claim 6, wherein the positive definite matrix B satisfies the following equation:

   DFP technique-based

$$B^{i+1} = \left(I - \frac{\Delta^i(\delta^i)^T}{(\Delta^i)^T\delta^i}\right)B^i\left(I - \frac{\delta^i(\Delta^i)^T}{(\Delta^i)^T\delta^i}\right) + \frac{\Delta^i(\Delta^i)^T}{(\Delta^i)^T\delta^i}$$

   where

$$\Delta^i = g(P_k^{i+1}) - g(P_k^i), \text{ and } \delta^i = P_k^{i+1} - P_k^i .$$

**8.** The Kalman filter channel estimation method as set forth in claim 6, wherein the positive definite matrix B satisfies the following equation:

BFGS technique-based

$$B^{i+1} = B^i + \frac{\Delta^i(\Delta^i)^T}{(\Delta^i)^T\delta^i} - \frac{B^i\delta^i(B^i\Delta^i)^T}{(\delta^i)^T B^i\delta^i}$$

where

$$\Delta^i = g(P_k^{i+1}) - g(P_k^i), \text{ and } \delta^i = P_k^{i+1} - P_k^i .$$

**9.** The Kalman filter channel estimation method as set forth in claim 6, wherein the positive defmite matrix B satisfies the following equation:

Broyden technique-based

$$B^{i+1} = B^i + \frac{\Delta^i - B^i\delta^i}{(\delta^i)^T\delta^i}(\delta^i)^T$$

where

$$\Delta^i = g(P_k^{i+1}) - g(P_k^i), \text{ and } \delta^i = P_k^{i+1} - P_k^i .$$

**10.** The Kalman filter channel estimation method as set forth in claim 6, wherein the positive definite matrix B satisfies the following equation:

Broyden Family technique-based

$$B^{i+1} = (1-\varphi_i)B^i_{BFGS} + \varphi_i B^i_{DFP}, \varphi_i \in [0,1].$$

**11.** The Kalman filter channel estimation method as set forth in claim 6, wherein the positive definite matrix B satisfies the following equation:

SR1 technique-based

$$B^{i+1} = B^i + \frac{(\Delta^i - B^i\delta^i)(\Delta^i - B^i\delta^i)^T}{(\Delta^i - B^i\delta^i)^T\delta^i}$$

where

$$\Delta^i = g(P_k^{i+1}) - g(P_k^i), \text{ and } \delta^i = P_k^{i+1} - P_k^i .$$

FIG. 1

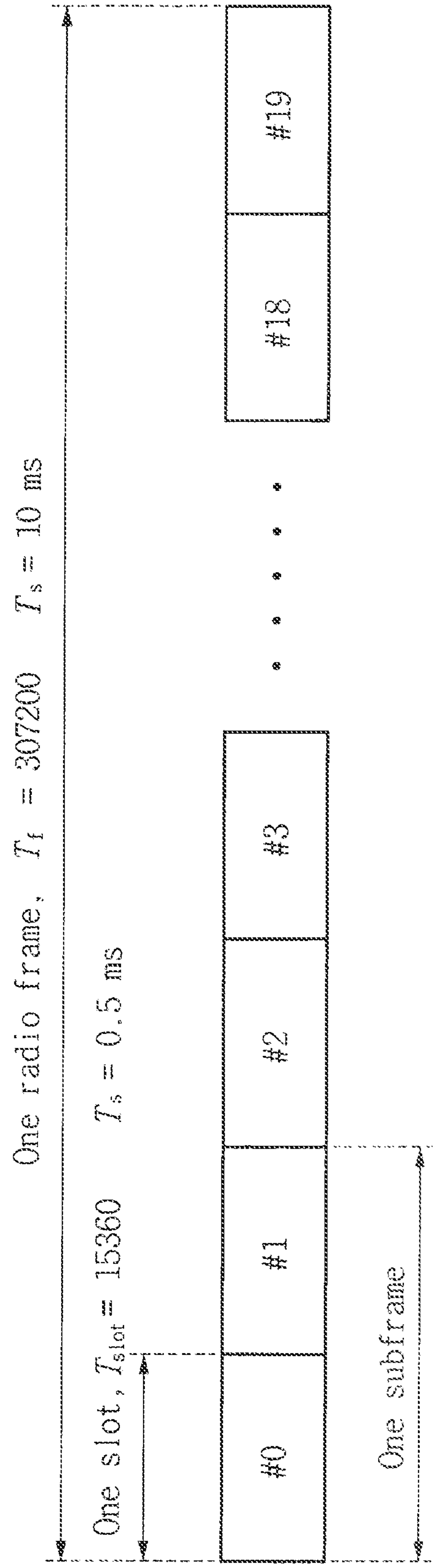
One radio frame, $T_f$ = 307200 $T_s$ = 10 ms
One slot, $T_{slot}$ = 15360 $T_s$ = 0.5 ms
#0
#1
#2
#3
#18
#19
One subframe

FIG.2

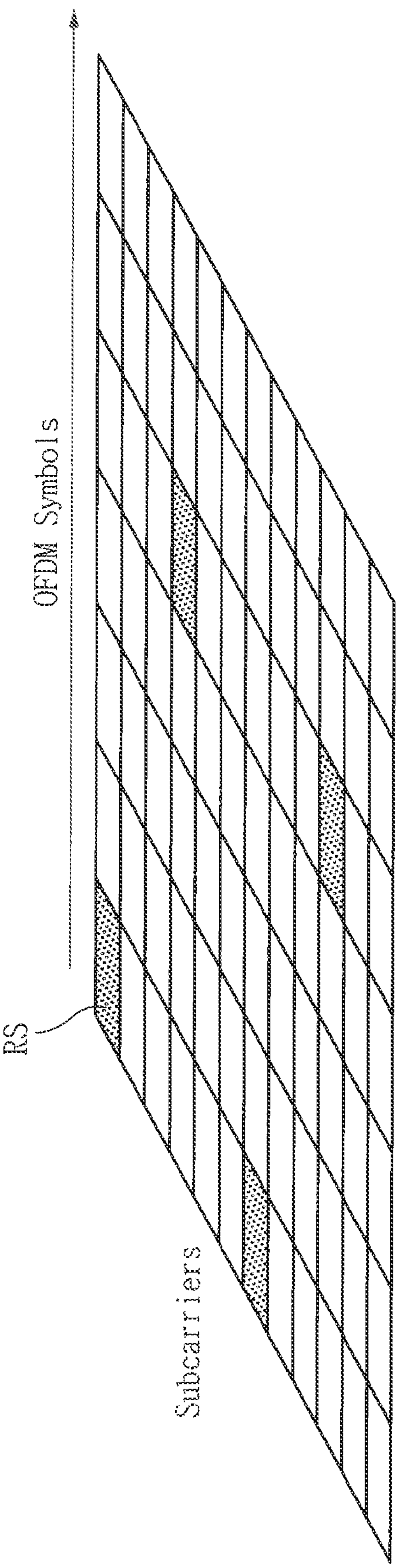

FIG.3

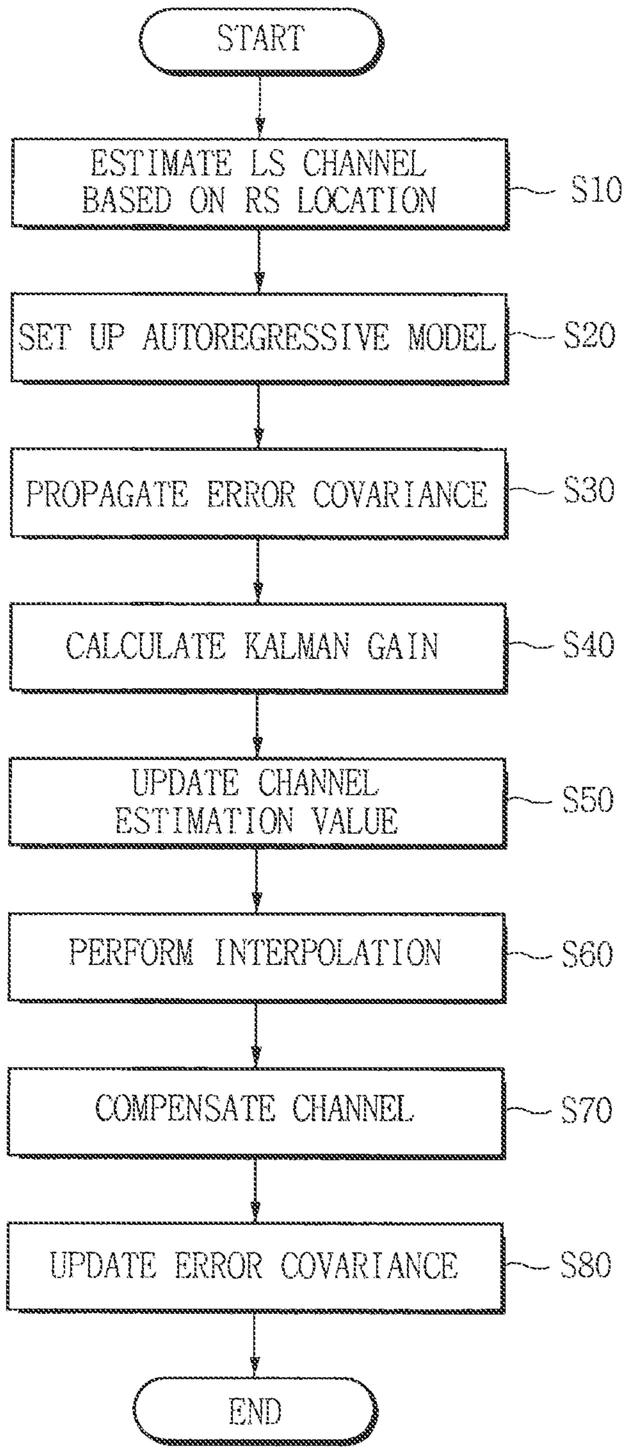
START
ESTIMATE LS CHANNEL BASED ON RS LOCATION
S10
SET UP AUTOREGRESSIVE MODEL
S20
PROPAGATE ERROR COVARIANCE
S30
CALCULATE KALMAN GAIN
S40
UPDATE CHANNEL ESTIMATION VALUE
S50
PERFORM INTERPOLATION
S60
COMPENSATE CHANNEL
S70
UPDATE ERROR COVARIANCE
S80
END

FIG.4

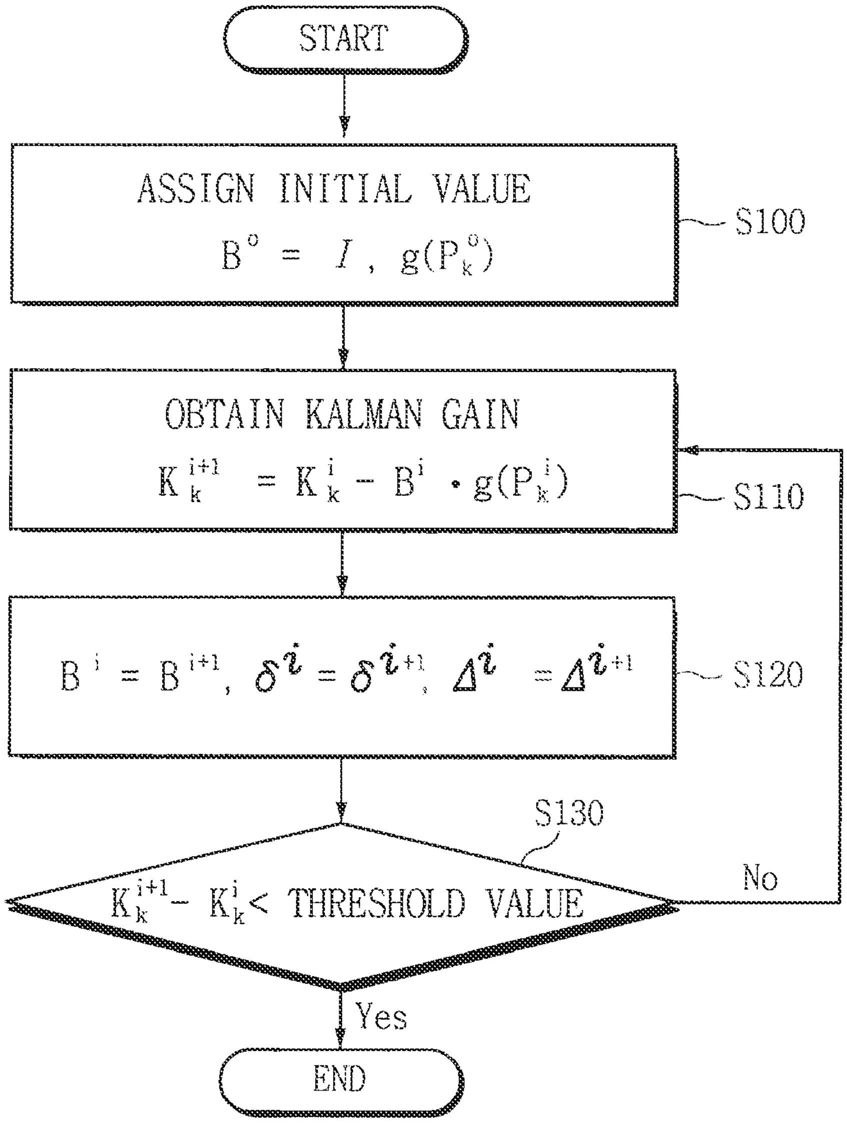
START
ASSIGN INITIAL VALUE
$B^o = I, g(P_k^o)$
S100
OBTAIN KALMAN GAIN
$K_k^{i+1} = K_k^i - B^i \cdot g(P_k^i)$
S110
$B^i = B^{i+1}, \delta^i = \delta^{i+1}, \Delta^i = \Delta^{i+1}$
S120
S130
$K_k^{i+1} - K_k^i <$ THRESHOLD VALUE
No
Yes
END

FIG.5

| TECHNIQUE | $B^{i+1}$ |
|---|---|
| DFP | $\left(I-\frac{\Delta^{i}(\delta^{i})^{T}}{(\Delta^{i})^{T}\delta^{i}}\right)B^{i}\left(I-\frac{\delta^{i}(\Delta^{i})^{T}}{(\Delta^{i})^{T}\delta^{i}}\right)+\frac{\Delta^{i}(\Delta^{i})^{T}}{(\Delta^{i})^{T}\delta^{i}}$ |
| BFGS | $B^{i}+\frac{\Delta^{i}(\Delta^{i})^{T}}{(\Delta^{i})^{T}\delta^{i}}-\frac{B^{i}\delta^{i}(B^{i}\Delta^{i})^{T}}{(\delta^{i})^{T}B^{i}\delta^{i}}$ |
| Broyden | $B^{i}+\frac{\Delta^{i}-B^{i}\delta^{i}}{(\delta^{i})^{T}\delta^{i}}(\delta^{i})^{T}$ |
| Broyden family | $(1-\varphi_{i})B^{i}_{BFGS}+\varphi_{i}B^{i}_{DFP},\varphi_{i}\in[0,1]$ |
| SR1 | $B^{i}+\frac{(\Delta^{i}-B^{i}\delta^{i})(\Delta^{i}-B^{i}\delta^{i})^{T}}{(\Delta^{i}-B^{i}\delta^{i})^{T}\delta^{i}}$ |

$\Delta^{i}=g(P_{k}^{i+1})-g(P_{k}^{i}),\quad \delta^{i}=P_{k}^{i+1}-P_{k}^{i}$

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020090127052
- KR 1020100048762